**Europäisches Patentamt**

**European Patent Office**

**Office européen des brevets**

(19)

(11) Veröffentlichungsnummer: **0 056 123**
**B2**

(12)
# NEUE EUROPÄISCHE PATENTSCHRIFT

(45) Veröffentlichungstag der neuen Patentschrift:
**16.03.88**

(21) Anmeldenummer: **81110347.2**

(22) Anmeldetag: **11.12.81**

(51) Int. Cl.⁴: **C 08 L 67/02,** C 08 L 51/00,
C 08 L 55/02

(54) **Verfahren zur Herstellung von thermoplastischen Formmassen.**

(30) Priorität: **09.01.81 DE 3100484**

(43) Veröffentlichungstag der Anmeldung:
**21.07.82 Patentblatt 82/29**

(45) Bekanntmachung des Hinweises auf die Patenterteilung:
**24.10.84 Patentblatt 84/43**

(45) Bekanntmachung des Hinweises auf die Entscheidung
über den Einspruch:
**16.03.88 Patentblatt 88/11**

(84) Benannte Vertragsstaaten:
**BE CH DE FR GB LI NL**

(56) Entgegenhaltungen:
**DE-A-2 144 528**
**FR-A-2 099 398**
**FR-A-2 285 435**
**US-A-3 723 373**
**US-A-4 156 669**

**Die Akte enthält technische Angaben, die nach
dem Eingang der Anmeldung eingereicht wurden
und die nicht in dieser Patentschrift enthalten sind.**

(73) Patentinhaber: **BASF Aktiengesellschaft, Carl-
Bosch- Strasse 38, D-6700 Ludwigshafen (DE)**

(72) Erfinder: **Bootz, Ludwig, Bad- Aussee- Strasse 61,
D-6700 Ludwigshafen (DE)**
Erfinder: **Brandstetter, Franz, Dr., Ritterbuechel 45,
D-6730 Neustadt (DE)**
Erfinder: **Sterzel, Hans- Josef, Dr., Wasgauring 3,
D-6701 Dannstadt- Schauernheim (DE)**

EP 0 056 123 B2

LIBER, STOCKHOLM 1988

## Beschreibung

Die Erfindung betrifft ein Verfahren zum Herstellen von Formmassen, die aus 10 bis 95 Gew.-Teilen eines linearen gesättigten Polyesters und 90 bis 5 Gew.-Teilen eines kautschukartigen Pfropfmischpolymerisats bestehen, durch Mischen der Komponenten in der Schmelze.

Mischungen von kautschukartigen Pfropfmischpolymerisaten mit Polyestern sind in der DE-OS Nr. 2 444 584 beschrieben. Die Herstellung dieser Mischungen erfolgt in Extrudern, wobei sowohl der Polyester als auch das Pfropfmischpolymerisat einen Wassergehalt von höchstens 0,02 % haben dürfen. Da das Pfropfmischpolymerisat normalerweise durch Polymerisation in wässerigem Medium und anschliessendem Ausfällen hergestellt wird, muss es mit aufwendigen Mitteln getrocknet werden, bevor es eingesetzt werden kann.

Der Erfindung lag also die Aufgabe zugrunde, ein technisch einfacheres Verfahren zur Herstellung von Formmassen zu entwickeln, die aus 10 bis 95 Gew.-Teilen eines linearen gesättigten Polyesters und 90 bis 5 Gew.-Teilen eines kautschukartigen Pfropfmischpolymerisats bestehen und die ein hohes Zähigkeitsniveau aufweisen.

Diese Aufgabe wird gelöst durch die im Patentanspruch 1 genannten Massnahmen.

Aus der DE-PS Nr. 2 037 784 ist ein Verfahren zum Einarbeiten von Kautschuk in thermoplastische Kunststoffe, vorzugsweise Styrolpolymerisate, bekannt, bei dem der Kautschuk aus einem Latex gefällt, bis zu einem Wassergehalt von 10 bis 40 Gew.-% mechanisch getrocknet und in die Schmelze des thermoplastischen Kunststoffs eingearbeitet wird. Es war nicht ohne weiteres naheliegend, dieses Verfahren auch bei thermoplastischen Polyestern anzuwenden, da diese bekanntlich hydrolyseempfindlich sind, so dass bei den anzuwendenden hohen Temperaturen eine Schädigung des Polyesters durch das Wasser zu befürchten war.

Unter Formmassen im Sinne der vorliegenden Erfindung sollen ungeformte Mischungen verstanden werden, die sich durch thermoplastische Verarbeitung innerhalb bestimmter Temperaturbereiche zu Formteilen oder zu Halbzeug verarbeiten lassen. Die Formmassen können z. B. als Granulat vorliegen, sie können aber auch pulverförmig oder durch Tablettierung vorgeformt oder in Form von Platten oder Bahnen vorliegen.

Als linearer gesättigter Polyester aromatischer Dicarbonsäuren wird vorzugsweise Polybutylenterephthalat verwendet. Man kann auch Polyethylenterephthalat sowie modifizierte Polyalkylenterephthalate verwenden, die neben Terephthalsäure noch andere aromatische oder auch aliphatische Dicarbonsäuren als Grundeinheiten, z. B. Naphthalindicarbonsäure-2,6 oder Adipinsäure enthalten. Ferner können modifizierte Polybutylenterephthalate eingesetzt werden, die neben Butandiol-1,4 noch andere aliphatische Diole, wie beispielsweise Neopentylglykol, Ethylenglycol oder Hexandiol-1,6, enthalten.

Die Polyester sollen eine relative Viskosität (gemessen an einer 0,5 %-igen Lösung Phenol/o-Dichlorbenzol 60 : 40 bei 25° C) zwischen 1,44 und 1,95, vorzugsweise zwischen 1,50 und 1,75, besitzen.

Bei den kautschukartigen Pfropfmischpolymerisaten handelt es sich um Propfpolymerisate von harte Polymere bildenden Monomeren auf eine weich elastische Pfropfgrundlage.

Die Herstellung des Pfropmischpolymerisates kann in zwei Stufen erfolgen. Hierzu wird zunächst die Pfropfgrundlage hergestellt.

Der Grundkautschuk ist durch seine Glastemperatur definiert, die unterhalb von 0, vorzugsweise unterhalb von -20° C, liegt. Die Bestimmung der Glastemperatur erfolgt dabei nach der von K. M. Illers, ”Kolloid-Zeitschrift”, 176, S. 110, 1961, angegebenen Methode. Dabei kommen beispielsweise in Frage: Naturkautschuk, Synthesekautschuke, wie Polybutadien, Polyisopren und Copolymerisate von Butadien mit Styrol oder Acrylnitril, ferner Elastomere auf Basis von Alkylestern der Acrylsäure, wobei der Alkylrest 1 bis 8 C-Atome enthält, Copolymerisate von Alkylestern der Acrylsäure mit Butadien, Styrol, Acrylnitril und Vinylethern sowie Copolymerisate aus Ethylen/Propylen und einer nichtkonjugierten Dienkomponente (EPDM-Kautschuke).

Der Kautschuk fällt bei seiner Herstellung im allgemeinen als Latex mit einer Teilchengrösse von 0,06 bis 1 µm an. Die Teilchengrösse des Kautschuklatex kann aber auch nach der Herstellung der Grundstufe durch weitere Massnahmen, wie Agglomeration und Saatfahrweise, vergrössert werden.

Zur Herstellung des Pfropfmischpolymerisates werden dann in einem zweiten Schritt in Gegenwart des Kautschuklatex Monomere, vorzugsweise Gemische von Styrol und Acrylnitril bzw. Styrol und einem Ester der Methacrylsäure polymerisiert, wobei das Gewichtsverhältnis von Styrol zu Acrylnitril bzw. von Styrol zum Ester der Methacrylsäure in dem Monomerengemisch im Bereich von 50 : 50 bis 95 : 5, vorzugsweise bei 80: 20 bis 70 : 30, liegt. Es ist vorteilhaft, diese Pfropfmischpolymerisation in wässeriger Emulsion unter den üblichen Bedingungen durchzuführen. Die aufzutropfenden Monomeren können dem Reaktionsgemisch auf einmal, absatzweise in mehreren Stufen oder vorzugsweise kontinuierlich während der Polymerisation zugegeben werden. Die Pfropfmischpolymerisation wird so geführt, dass vorzugsweise ein Pfropfgrad von 20 bis 50 Gew.-% im Pfropfmischpolymerisat resultiert, Da die Pfropfausbeute bei der Pfropfmischpolymerisation nicht 100 %-ig ist, muss eine etwas grössere Menge der Monomeren bei der Pfropfmischpolymerisation eingesetzt werden, als es dem gewünschten Pfropfgrad entspricht. Die Steuerung der Pfropfausbeute bei der Pfropfmischpolymerisation und somit des Pfropfgrades des Pfropfmischpolymerisates ist jedem Fachmann geläufig und kann beispieisweise u.a. durch die Dosiergeschwindigkeit der Monomeren oder durch Reglerzugabe erfolgen.

Die in wässeriger Dispersion erhaltenen Pfropfmischpolymerisate werden ausgefällt und mechanisch teilweise entwässert, so dass sie einen Wassergehalt von 5 bis 50, vorzugsweise von 10 bis 40 Gew.-%, aufweisen.

Im einzelnen geht man bei dem erfindungsgemässen Verfahren dann so vor, dass vorzugsweise zunächst das feuchte Pfropfmischpolymerisat in die Mischvorrichtung eindosiert wird. Dies kann ohne Erhitzen oder Anwendung von Druck geschehen; anschliessend wird dann in eine 2. Zone der Mischvorrichtung der geschmolzene Polyester zugeführt.

Nach der Vereinigung des Pfropfmischpolymerisates und der Schmelze des Polyesters werden die Komponenten durch Mischaggregate, beispielsweise durch intensiv mischende Knetelemente der Mischvorrichtung, z. B. einen Extruder, homogen vermischt. Dabei soll die Mischstrecke des Pfropfkautschuks mit der Schmelze des Polyesters im Bereich von 3 bis 35, vorzugsweise von 6 bis 20 D, liegen, wobei die Temperatur oberhalb des Erweichungspunktes des Polyesters liegen muss, d.h. im allgemeinen im Temperaturbereich zwischen 240 und 320, vorzugsweise 250 bis 280°C.

Die üblicherweise angewendeten Zusatzstoffe werden zweckmässigerweise zusammen mit dem Pfropfmischpolymerisat in feuchter oder trockener Form zugegeben.

Zur Entfernung des Wassers werden Entgasungsvorrichtungen, die am Extruder in Förderrichtung nach der Mischzone angebracht sind, verwendet. Es muss darauf geachtet werden, dass durch diese Öffnungen mit dem Dampf kein Feststoff mitgerissen wird. Dies kann beispielsweise durch den Einbau von Entgasungsstopfschnecken in die Extruderöffnungen geschehen, wodurch mitgerissenes Festprodukt in den Hauptextruder zurückbefördert wird. Die Entgasung kann mit Gegendruck, drucklos oder vorzugsweise bei vermindertem Druck erfolgen. Es ist zweckmässig, mehrere Entgasungsstufen hintereinander vorzusehen, wobei in Förderrichtung des Hauptextruders der Gegendruck stufenweise abnehmen soll. Zusammen mit dem Wasser werden wasserdampfflüchtige Bestandteile entfernt.

Durch das Verdampfen des Wassers wird infolge seiner hohen Verdampfungswärme der Schmelze Energie entzogen. Aus diesem Grund ist es möglich, durch Variation der Wassermenge im Pfropfmischpolymerisat ein für das Mischen der Einsatzstoffe optimales Temperaturprofil über die Länge der Mischvorrichtung einzustellen: je mehr Wasser die Feuchtgüter enthalten, desto mehr Energie muss für die Verdampfung aufgebracht werden, desto mehr Wärme wird also der Schmelze entzogen und desto niedriger liegt das Temperaturniveau der Schmelze.

Die nach dem erfindungsgemässen Verfahren erhaltenen Mischungen können als weitere Komponente alle Zusatz- und/oder Hilfsstoffe enthalten, wie sie für lineare gesättigte Polyester gebräuchlich sind. Als solche Zusatz- und/oder Hilfsstoffe seien beispielsweise genannt; Füllstoffe, Verstärkungsmittel, insbesondere Glasfasern, weitere verträgliche Polymerisate, Farbstoffe oder Pigmente, Antistatika, Antioxidantien, Flammschutzmittel und Schmiermittel. Die Zusatz- und Hilfsstoffe werden in üblichen und wirksamen Mengen, vorzugsweise in Mengen von 0,1 bis zu insgesamt etwa 50 Gew.-%, bezogen auf die Mischung eingesetzt.

Nach dem erfindungsgemässen Verfahren können direkt schlagzäh modifizierte Polyester hergestellt werden, wenn man beispielsweise etwa 5 bis 20 Gew.-% Pfropfmischpolymerisat in den Polyester einarbeitet. Man kann aber auch Konzentrate mit einem Pfropfmischpolymerisatgehalt von beispielsweise 50 bis 90 Gew.-% herstellen und diese dann in einem zweiten Arbeitsgang mit der Hauptmenge eines Polyesters abmischen.

**Beispiele**

In Polybutylenterephthalat (PBTP) mit einer relativen Viskosität von 1,65 (gemessen als 0,05 %-ige Lösung in einem Gemisch aus Phenol/o-Dichlorbenzol im Gewichtsverhältnis 3 : 2 bei 25°C) wurde ein Pfropfkautschuk zur Erzielung einer erhöhten Schlagzähigkeit eingearbeitet. Als Pfropfkautschuk diente ein Pfropfmischpolymerisat von 30 Gew.-Teilen einer Mischung von Styrol und Acrylnitril im Gewichtsverhältnis 75 : 25 auf 70 Gew.-Teile eines Mischpolymerisats aus 96 Gew.-% Butylacrylat und 4 Gew.-% Dicyclopentadienylacrylat.

Zur Beurteilung der Verarbeitungsstabilität wurde die relative Viskosität nach dem Einarbeitungsschritt gemessen. Zur Prüfung der Schlagzähigkeit wurden auf einer Spritzgussmaschine bei 260°C Kunststofftemperatur und 60°C Formtemperatur Normkleinstäbe nach DIN 53 453 mit den Massen 4x6x50 mm hergestellt. In Anlehnung an den Schlagbiegeversuch nach DIN 53 453 wurde die Lochkerbschlagzähigkeit folgendermassen gemessen:

In die Mitte der 6x50-mm-Fläche wurden Löcher mit 3 mm Durchmesser gebohrt. Mittels eines Pendelschlagwerks wurde die Bruchenergie in Kilojoule pro Quadratmeter bei 23°C gemessen. Die Messwerte sind in der Tabelle aufgeführt.

**Beispiel 1:**

Es wurde ein Zweiwellenextruder mit sechs Heizzonen eingesetzt. Die Heizzonen wurden in Richtung vom Einzug bis zur Düse hin auf 150, 190, 250, 240, 240 und 240°C gebracht. In der Einzugszone wurden 3,1 kg/h Pfropfkautschuk mit 35 Gew.-% Wassergehalt zudosiert und in den ersten zwei Heizzonen erwärmt. In die 3. Heizzone wurden 18 kg/h 250°C heisse PBTP-Schmelze zudosiert. An die Entgasungsstufen der beiden folgenden Heizzonen wurde eine Vakuumpumpe angeschlossen, die den Dampfdruck in diesen Zonen auf 200 mbar erniedrigte und den Wasserdampf abzog.

Die aus der Düse tretende Schmelze wurde in einem Wasserbad abgekühlt, der Strang granuliert und das Granulat zur Spritzgussverarbeitung getrocknet. Das so erhaltene PBTP wies einen Pfropfkautschukgehalt von 10 Gew.-% auf.

**Vergleichsbeispiel**

Zum Vergleich wurden im selben Extruder wie in Beispiel 1 18 kg/h PBTP ohne Zusatz von Pfropfkautscuk durchgesetzt.

**Beispiel 2:**

Mit der Extruderanordnung aus Beispiel 1, den gleichen Temperatur- und Vakuumbedingungen wurden 9 kg/h PBTP und 28 kg/h Pfropfkautschuk mit 35 % Wassergehalt zudosiert.

Damit wurde ein Konzentrat mit 65 Gew.-% Pfropfkautschuk erhalten.

Mit einem Durchsatz von 27 kg/h PBTP und 4,6 kg/h dieses Konzentrates wurde mittels eines anderen Extruders bei 250°C eine PBTP/Pfropfkautschuk-Mischung mit 10 Gew.-% Pfropfkautschuk hergestellt.

Die Beispiele zeigen, dass es möglich ist, Pfropfkautschuke mit hohem Wassergehalt in Polybutylenterephthalat einzumischen, ohne dass es zu dem zu erwartenden hydrolytischen Abbau des Polyesters kommt.

Die beiden Verfahrensweisen, nämlich die direkte Einmischung oder der Weg über ein Konzentrat, ergeben keine signifikanten Unterschiede in der Schlagzähigkeit.

**Tabelle**

| | Ver-gleichs-beispiel | Bei-spiel 1 | Bei-spiel 2 |
|---|---|---|---|
| Rel. Viskosität | 1,62 | 1,61 | 1,62 |
| Locherbschlag-zähigkeit (kJ/ m²) | 48 | 67 | 70 |

**Patentansprüche**

1. Verfahren zur Herstellung einer Formmasse aus 10 bis 95 Gew.-Teilen eines linearen gesättigten Polyesters, und 90 bis 5 Gew.-Teilen eines kautschukartigen Pfropfmischpolymerisates, hergestellt aus einem Kautschuklatex mit einer Glastemperatur unter 0°C durch Aufpolymerisieren von harte Polymere bildenden Monomeren, sowie gegebenenfalls üblichen Zusatzstoffen durch Mischen der Komponenten in der Schmelze in Mischvorrichtungen, die mehrere Einspeisungszonen aufweisen und, nach einer Mischstrecke angeordnet, mindestens eine Entgasungszone besitzen, <u>dadurch gekennzeichnet</u>, daß man das Pfropfmischpolymerisat, welches einen Wassergehalt von 5 bis 50 Gew.-% aufweist, und die Schmelze des Polyesters in verschiedene Zonen der Mischvorrichtung einführt.

2. Verfahren nach Anspruch 1, <u>dadurch gekennzeichnet</u>, daß man als harte Polymere bildende Monomere Gemische von Styrol und Acrylnitril oder Styrol und einem Ester der Methacrylsäure im Gewichtsverhältnis 50 : 50 bis 95 : 5 verwendet.

3. Verwendung der Mischungen gemäß Patentanspruch 1 zur Herstellung von Formteilen.

**Claims**

1. A process for the production of a moulding material, comprising 10 to 95 parts by weight of a linear saturated polyester, and 90 to 5 parts by weight of an elastomeric graft copolymer prepared from a rubber latex having a glass transition temperature of less than 0°C by polymerizing onto said latex a monomer forming a hard polymer, and, if desired, also comprising conventional additives, by mixing the components in the melt in a mixing apparatus which has a plurality of feed zones and at least one devolatilizing zone arranged downstream of a mixing zone, wherein the graft copolymer which has a water content of from 5 to 50 % by weight, and the polyestar melt are fed into different zones of the mixing apparatus.

2. A process as claimed in claim 1, wherein there is used, as the monomer forming a hard polymer, a mixture of styrene and acrylonitrile or of styrene and a methacrylate in a weight ratio of from 50 : 50 to 95 : 5.

3. The use of a material as claimed in claim 1 for the production of moulded parts.

**Revendications**

1. Procédé de préparation d'une matière de moulage constituée par 10 à 95 % en poids d'un polyester saturé linéaire et 90 à 5 % en poids d'un copolymérisat greffé, préparé à partir d'un latex de caoutchouc d'une température de transition vitreuse inférieure à 0° C, par polymérisation de monomères formant des polymères durs, ainsi qu'éventuellement des additifs usuels, par mélange des composants dans la masse fondue dans des appareils mélangeurs qui comportent plusieurs zones d'introduction et possèdent au moins une zone de dégazage située en aval d'une section de mélange caractérisé par le fait qu'on introduit le copolymérisat greffé, qui possède une teneur en eau de 5 à 50 % en poids, et la masse fondue du polyester en différentes zones de l'appareil mélangeur.

2. Procédé selon la revendication 1, caractérisé par le fait qu'on utilise, comme monomères formant des polymères durs, des mélanges de styrène et acrylonitrile ou de styrène et d'un ester d'acide méthacrylique, en proportions en poids de 50/50 à 95/5.

3. Utilisation des mélanges selon la revendication 1 pour la fabrication de pièces moulées.